# EUROPEAN PATENT SPECIFICATION

(11) **EP 3 731 282 B1**
(45) Date of publication and mention of the grant of the patent: **17.05.2023**
(21) Application number: 18902425.0
(22) Date of filing: 27.12.2018
(51) Int. Cl.: H01L 31/05, H01L 31/054, H01L 31/0224, H01L 31/042, H01L 31/048

(54) **SOLAR BATTERY MODULE**
SOLARBATTERIEMODUL
MODULE DE BATTERIE SOLAIRE

(30) Priority: 25.01.2018 JP 2018010332
(43) Date of publication of application: 28.10.2020
(73) Proprietor: Kaneka Corporation, Osaka-shi, Osaka 530-8288 (JP)
(72) Inventor: TERASHITA, Toru, Settsu-shi, Osaka 566-0072 (JP); KOJIMA, Kohei, Settsu-shi, Osaka 566-0072 (JP)
(74) Representative: V.O.
(86) International application number: PCT/JP2018/048033
(87) International publication number: WO 2019/146366

(56) References cited:
- EP-A1- 3 855 508
- WO-A1-2014/162790
- WO-A1-2015/152020
- WO-A1-2016/188146
- WO-A1-2017/217219
- JP-A- 2005 019 901
- JP-A- 2015 534 288
- JP-A- 2015 534 288
- JP-A- 2018 163 988
- KR-B1- 101 816 164
- KR-B1- 101 816 164

## Description

### TECHNICAL FIELD

The present invention relates to a solar cell module.

### BACKGROUND ART

A single solar cell cannot achieve a high output power due to its small area. For this reason, in general, a plurality of solar cells are electrically connected and linked one after another to form a solar cell module, for the purpose of achieving high output power. For example, Patent Document 1 discloses a solar cell module including a plurality of back-electrode type solar cells each of which has both an n-type electrode and a p-type electrode on its back surface, i.e., on the opposite side of the light receiving surface. The plurality of solar cells are shingling-connected by overlapping a first end of each solar cell with a second end of another solar cell. Solar cells interconnected in a shingled manner are also disclosed in KR 101 816 164 B1, JP 2015 534288 A, EP 3 855 508 A1 and WO 2016/188146 A1.

### CITATION LIST

### PATENT DOCUMENT

Patent Document 1: Japanese Patent Publication No. 2015-534288

### SUMMARY OF THE INVENTION

The invention is as defined in claim 1. The preferred embodiments are set out in the appended set of dependent claims.

### BRIEF DESCRIPTION OF THE DRAWINGS

FIG. 1A is a cross-sectional view of a portion of a solar cell module not forming part of the present invention.
FIG. 1B is an enlarged cross-sectional view of a main part of the solar cell module not forming part of the present invention.
Fig. 2A is a front view showing a connection structure of a conductive connecting member to a first electrode on a back surface of a solar cell.
Fig. 2B is a front view showing a modification of a connection structure of the conductive connecting member to the first electrode on the back surface of the solar cell.
Fig. 3A is a front view showing a connection structure of the conductive connecting member to a second electrode on the back surface of the solar cell.
Fig. 3B is a front view of a modification showing a connection structure of the conductive connecting member to the second electrode on the back surface of the solar cell.
FIG. 4 is an enlarged cross-sectional view of a main part of a modification of the solar cell module according to the embodiment of the present invention.
FIG. 5 is a front view of a back surface of a large-sized solar cell.
FIG. 6 is a front view of a back surface of the solar cell.
FIG. 7A is an enlarged cross-sectional view of a main part of another modification of the solar cell module according to the embodiment of the present invention.
FIG. 7B is a plan view of the main part of the another modification of the solar cell module according to the embodiment of the present invention.
FIG. 8 is a plan view of a yet another modification of a main part of the solar cell module according to the embodiment of the present invention.
FIG. 9A is a cross-sectional view of a reflector in which ridges having a triangular cross-section and extending in a length direction are formed and aligned in a width direction.
FIG. 9B is a cross-sectional view of a reflector with a ridge having a semicircular cross-section and extending in the length direction.

### DESCRIPTION OF EMBODIMENTS

The following describes in detail embodiments.

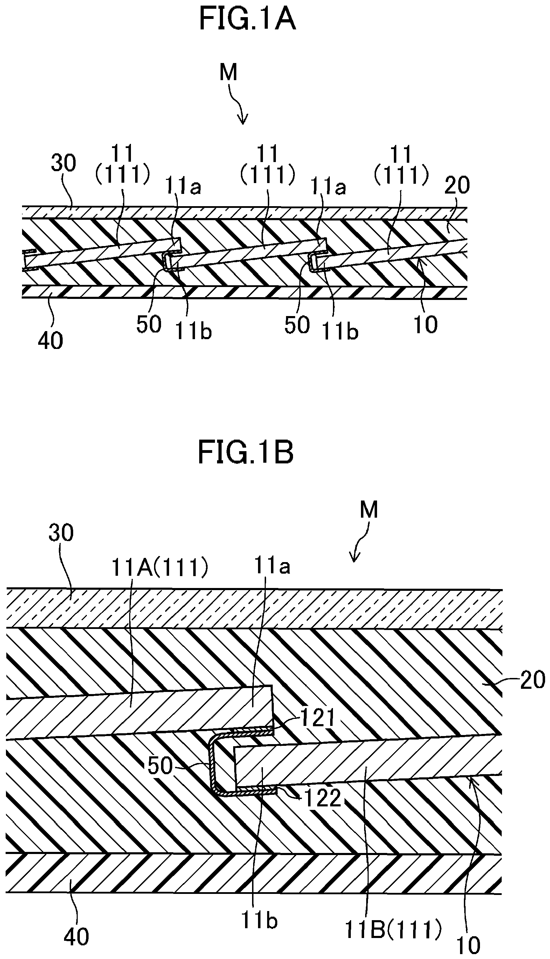

FIG. 1A and FIG. 1B illustrate a solar cell module M according to an example not forming part of the present invention.

The solar cell module M according to the example includes: a solar cell string 10; an encapsulant layer 20 in which the solar cell string 10 is embedded in its intermediate portion relative to the thickness direction; a light receiving surface side protective member 30 stacked on a light receiving surface side of the encapsulant layer 20; and a back surface side protective member 40 stacked on the back surface side of the encapsulant layer 20.

The solar cell string 10 has a plurality of solar cells 11 connected and linked one after another electrically and mechanically. In other words, a plurality of solar cells 11 are in a series like a string in appearance, and if the solar cells 11 are electrically connected to one another, this series of the solar cells 11 are referred to as a solar cell string 10.

Each of the plurality of solar cells 11 includes an n-type or p-type semiconductor substrate 111 serving as a cell body, an n-type semiconductor layer (not shown), and a p-type semiconductor layer (not shown). An example of the n-type semiconductor substrate 111 is a single crystal silicon substrate and the like into which an n-type dopant such as phosphorus is doped to introduce electrons into silicon atoms. An example of the p-type semiconductor substrate 111 is a single crystal silicon substrate and the like into which a p-type dopant such as boron is doped to introduce positive holes into silicon atoms. In the following description, one of the two major surfaces of each of the solar cell 11 and the semiconductor substrate 111 will be referred to as a back surface, and the other major surface, which is opposite to the one of the major surfaces, as a light receiving surface.

An example of the n-type semiconductor layer is a silicon-based thin film layer doped with an n-type dopant, which layer is layered on the semiconductor substrate 111. An example of the p-type semiconductor layer is a silicon-based thin film layer doped with a p-type dopant, which layer is layered on the semiconductor substrate 111.

Each solar cell 11 has, on its back surface, a first electrode 121 that is one of an n-type electrode electrically connected to the n-type semiconductor layer or a p-type electrode electrically connected to the p-type semiconductor layer, and a second electrode 122 that is the other one of the n-type electrode or the p-type electrode. Such a solar cell 11 is referred to as a "back-contact type." The first electrode 121 and the second electrode 122 collect carriers such as positive holes or electrons.

The first electrode 121 and the second electrode 122 are a metal electrode in one preferred example, not forming part of the present invention.

A transparent conductive layer such as a metal oxide may be provided between the first electrode 121 and the semiconductor layer underlying the first electrode 121 and between the second electrode 122 and the semiconductor layer underlying the second electrode 122. The first electrode 121 and the second electrode 122, which are each a metal electrode, are formed by a well-known method such as printing or plating. Specifically, for example, an Ag electrode is formed by screen printing using an Ag paste, and a copper-plated electrode is formed by electrolytic plating.

In one preferred example not forming part of the present invention, the plurality of solar cells 11 have an uneven structure formed on their light receiving surfaces to take in a large amount of light and enhance their conversion efficiency. In one preferred example not forming part of the present invention, the uneven structure is an aggregate of quadrangular pyramid shapes (pyramid shapes). The uneven structure with the pyramid shapes can be formed by, for example, subjecting the surface of the semiconductor substrate 111 to an anisotropic etching treatment. The unevenness of the uneven structure has a height of, for example, 0.5 µm or more and 10 µm or less, and preferably 1 µm or more and 5 µm or less. Note that the uneven structure may also be formed on the back surfaces of the solar cells 11.

Each of the plurality of solar cells 11 has a first end 11a and a second end 11b arranged so as to extend in parallel. A given pair of solar cells 11 (one of which is a solar cell 11A and the other is a solar cell 11B) adjacent to each other out of the plurality of solar cells 11 are electrically and mechanically connected to each other by placing the back surface of the first end 11a of the one solar cell 11A so as to overlap with the light receiving surface of the second end 11b of the other solar cell 11B. As described above, since the solar cells 11 are arranged and connected to each other as shingling on a roof, such connection is referred to as a shingling connection. An overlapping width of the first end 11a of the one solar cell 11A and the second end 11b of the other solar cell 11B is, for example, 0.5 mm or more and 3.0 mm or less.

The first electrode 121 of the one solar cell 11A and the second electrode 122 of the other solar cell 11B are electrically connected through a conductive connecting member 50. The conductive connecting member 50 is, for example, a strip of metal foil having a thickness of 10 µm or more and 100 µm or less, which is shaped to have a U-shaped cross-section (in other words, a warped shape). In one preferred example not forming part of the present invention, the metal material for forming the metal foil is copper or a copper alloy containing copper as a main component, or aluminum or an aluminum alloy containing aluminum as a main component, for the sake of lower costs. The metal foil forming the conductive connecting member 50 may be plated with solder, tin, nickel, or silver, or may be coated with a conductive paste or a conductive adhesive.

The conductive connecting member 50 is arranged so that its interior side of the warped shape covers the second end 11b of the other solar cell 11B, that is, the lower side (e.g., the back surface side of the solar cell module M) of the solar cells 11A and 11B layered on each other. That is, the conductive connecting member 50 curves around the end of the other solar cell 11B, which is one of the solar cells 11A and 11B layered on each other, from the back surface to the light receiving surface of the solar cell 11B. A portion of the interior side of the warped shape, which portion is one end of the conductive connecting member 50, is electrically connected to the second electrode 122 on the back surface of the second end 11b of the other solar cell 11B, via a connecting material. That is, the conductive connecting member 50 curving around the end of the other solar cell 11B so as to overlap with both major surfaces of the other solar cell 11B has a portion facing the back surface of the other solar cell 11B (i.e., facing one of the major surfaces of the other solar cell 11 away from the one solar cell 11A layered on the solar cell 11B), and the portion is connected to the second electrode 122 via the connecting material.

Further, the other end of the conductive connecting member 50 opposite to the one end connected to the second electrode 122 on the back surface of the second end 11b of the other solar cell 11B, is defined as follows. That is, a portion of the exterior side of the warped shape, which portion is the other end of the conductive connecting member 50, is electrically connected, via a connecting material, to the first electrode 121 on the back surface of the first end 11a of the one solar cell 11A, that is, the upper side (e.g., the light receiving surface side of the solar cell module M) of the solar cells 11A and 11B layered on each other. In other words, the conductive connecting member 50 curving around the end of the other solar cell 11B so as to overlap with both major surfaces of the other solar cell 11B has a portion facing the back surface of the one solar cell 11A of the solar cells 11A and 11B layered on each other, and the portion is connected to the first electrode 121 of the one solar cell 11A via the connecting material.

Examples of the connecting material include solder, a solder paste containing solder particles, a conductive paste containing metal particles, and the like. However, the connecting material is not limited to this and an insulative connecting material (e.g., adhesive) may be adopted as long as the conductive connecting member 50 and the electrode (the first electrode 121 and the second electrode 122) can be connected in a conductive manner.

In the solar cell module M of the present embodiment, the conductivity type of the semiconductor substrate 111 which is the cell body of the solar cell 11 is the same as the conductivity type of the semiconductor layer to which the second electrode 122 is electrically connected. That is, in a case in which the semiconductor substrate 111 of the solar cell 11 is an n-type semiconductor substrate, the second electrode 122 on the back surface of the second end 11b of the other solar cell 11B arranged on the back surface side of the semiconductor substrate 111 is an n-type electrode, and the first electrode 121 on the back surface of the first end 11a of the one solar cell 11A arranged on the light receiving surface side of the semiconductor substrate 111 is a p-type electrode. Further, in a case in which the semiconductor substrate 111 of the solar cell 11 is a p-type semiconductor substrate, the second electrode 122 on the back surface of the second end 11b of the other solar cell 11B arranged on the back surface side of the semiconductor substrate 111 is a p-type electrode, and the first electrode 121 on the back surface of the first end 11a of the one solar cell 11A arranged on the light receiving surface side of the semiconductor substrate 111 is an n-type electrode.

According to the solar cell module M of the present embodiment, the conductive connecting member 50 is provided between the first electrode 121 on the back surface of the one solar cell 11A arranged on the light receiving surface side and the second electrode 122 on the back surface of the other solar cell 11B arranged on the back surface side. Since the conductivity type of the semiconductor substrate 111 and that of the semiconductor layer to which the second electrode 122 is electrically connected are the same, even if the conductive connecting member 50 contacts the semiconductor substrate 111 of the other solar cell 11B, a leak path is not formed, and hence, shunt resistance does not decrease. This makes it possible to increase power generation efficiency. For the sake of high power generation efficiency, the conductivity type of the semiconductor substrate 111 and the conductivity type of the semiconductor layer to which the second electrode 122 is electrically connected are n-type according to the present invention.

Further, according to the solar cell module M of the present embodiment, the shingling connection achieves high design characteristics, in which the connection structure of the electrodes is invisible from the light receiving surface side.

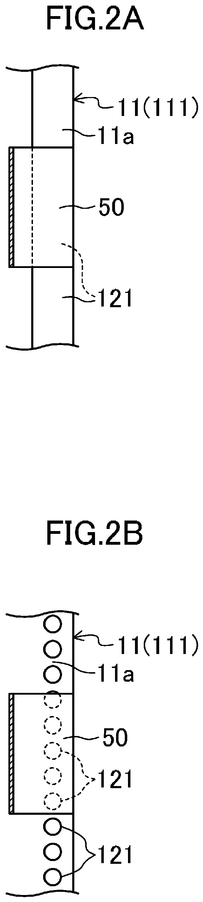

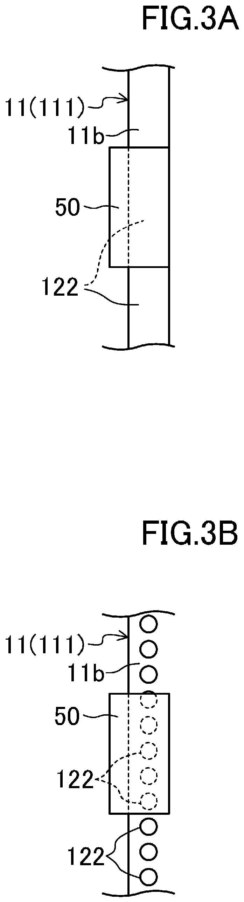

The conductive connecting member 50 is electrically connected to the first electrode 121 on the back surface of the one solar cell 11A, at a linear portion arranged along the first end 11a of the one solar cell 11A as shown in FIG. 2A, or at a portion made of a series of dots arranged along the first end 11a as shown in FIG. 2B. Further, the conductive connecting member 50 is electrically connected to the second electrode 122 on the back surface of the other solar cell 11B, at a linear portion arranged along the second end 11b of the other solar cell 11B as shown in FIG. 3A, or at a portion made of a series of dots arranged along the second end 11b as shown in FIG. 3B.

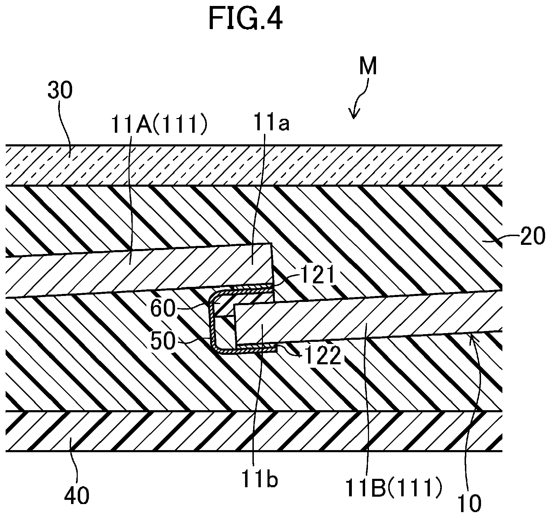

Between the conductive connecting member 50 and the other solar cell 11B, an insulative buffer member 60 is interposed as shown in FIG. 4. The insulative buffer member 60 is provided so as to cover a portion of the light receiving surface of the other solar cell 11B, including the edge of the second end 11b, and a portion of the side end surface of the other solar cell 11B. The insulative buffer member 60 interposed between the conductive connecting member 50 and the other solar cell 11B as described above serves as a cushion when a pressure acts on the conductive connecting member 50 at a time of encapsulating the solar cell string 10 into the encapsulant layer 20. This keeps the conductive connecting member 50 from contacting the other solar cell 11B, thus avoiding a crack in the solar cell 11B. Moreover, since a great force acts on the edge of the second end 11b of the other solar cell 11B, the insulative buffer member 60 provided so as to cover the edge of the light receiving surface of the second end 11b of the other solar cell 11B produces a significantly high crack-avoidance effect.

In one preferred embodiment, the insulative buffer member 60 is transparent to reduce a drop in the amount of light received, which drop is caused by the insulative buffer member 60 sticking out from the first end 11a of the one solar cell 11A overlapped with the second end 11b of the other solar cell 11B, due to a pressure acting at the time of encapsulating the solar cell string 10 into the encapsulant layer 20. Examples of the insulative buffer member 60 include polyimide (PI), polyethylene terephthalate (PET), ethylene/vinyl acetate copolymer (EVA), acrylic resin, polyvinyl fluoride resin, olefin-based resins, and the like.

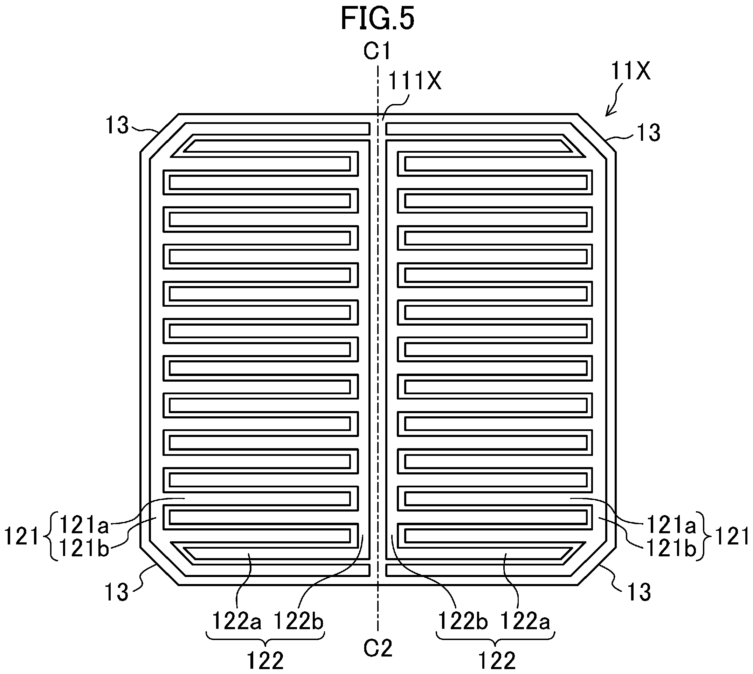

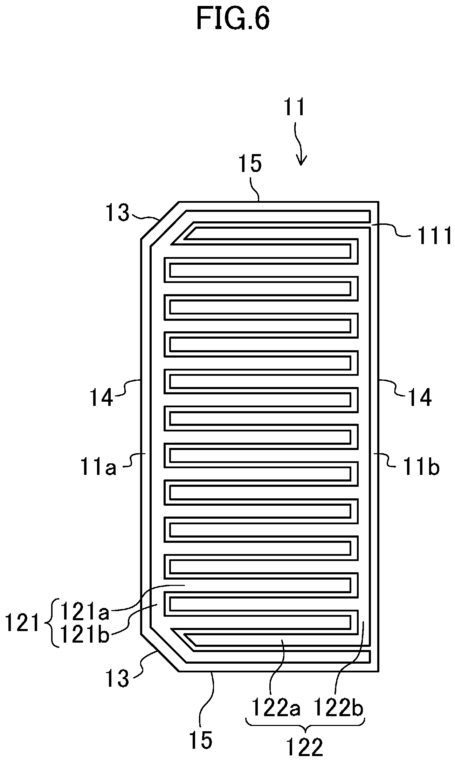

The solar cell 11 may be configured as a divided piece obtained by dividing a large-sized solar cell 11X shown in FIG. 5. FIG. 6 shows an example of such a solar cell 11.

The large-sized solar cell 11X is formed in a semi-square shape having a side length of, for example, approximately 20 mm or more and 200 mm or less and having a cut-out portion 13 at each of four corners. The solar cell 11 is obtained by dividing the large-sized solar cell 11X into two parts by a line C1 to C2 in the middle of FIG. 5. Therefore, the solar cell 11 is formed with long sides 14 of, for example, approximately 20 mm or more and 200 mm or less in length, and with short sides 15 of, for example, 10 mm or more and 100 mm or less in length (approximately a half of the long side), and the cut-out portions 13 are provided at both ends (i.e., corners) of one of the long sides 14. In the case in which the solar cells 11 obtained by dividing such a large-sized solar cell 11X are used for forming the solar cell module M, the larger number of divided solar cells 11 are mounted in a limited mounting area, compared to the number of large-sized solar cells 11X. That is, the amount of mounting the solar cells (power generation area) in the solar cell module M is enlarged. Therefore, the solar cell module M with the divided solar cells 11 mounted thereon can increase the amount of power generation compared to a solar cell module M with the large-sized solar cells 11X mounted thereon.

The large-sized solar cell 11X has a back surface that corresponds to a surface of a large-sized semiconductor substrate 111X. The surface of the large-sized semiconductor substrate 111X is divided into areas that will be two semiconductor substrates 111 where solar cells 11 are to be built. Each of the semiconductor substrates 111 includes a first conductivity type area which is one of an n-type area or a p-type area and a second conductivity type area which is the other one of the n-type area or the p-type area. The first and second conductivity type areas are formed through semiconductor stacking means. Using a known method, the first electrode 121 is arranged on the first conductivity type area and the second electrode 122 is arranged on the second conductivity type area. To form the first conductivity type area and the second conductivity type area, a technology to form a doping area in the large-sized semiconductor substrate 111X and a technology to form a semiconductor thin film, such as an amorphous silicon thin film, on the large-sized semiconductor substrate 111X are adopted. In a case of arranging an n-type or p-type conductive semiconductor thin film on the large-sized semiconductor substrate 111X, an intrinsic semiconductor thin film, such as an intrinsic amorphous silicon thin film, is arranged between the large-sized semiconductor substrate 111X and the conductive semiconductor thin film. Doing so produces a passivation effect on the surface of the large-sized semiconductor substrate 111X.

In one preferred embodiment, the first electrode 121 and the second electrode 122 are patterned in a comb-like shape so that the comb-teeth mesh with each other. More specifically, the first electrode 121 is formed in a comb-like shape having a plurality of first electrode finger portions 121a and a single first electrode busbar portion 121b. The plurality of first electrode finger portions 121a each extend parallel to the short sides 15 of the solar cell 11, and are arranged apart from one another in a direction in which the long sides 14 of the solar cell 11 extend. The first electrode busbar portion 121b is arranged so as to extend along the long side 14 having the cut-out portions 13 of the solar cell 11, that is, along a first end 11a, so as to connect the ends of the first electrode finger portion 121a on that long side 14. The second electrode 122 is also formed in a comb-like shape having a plurality of second electrode finger portions 122a and a single second electrode busbar portion 122b. The plurality of second electrode finger portions 122a each extend parallel to the short sides 15 of the solar cell 11, and are arranged apart from one another in a direction in which the long sides 14 of the solar cell 11 extend. The second electrode busbar portion 122b is arranged so as to extend along the long side 14 having the cut-out portions 13 of the solar cell 11, that is, along a second end 11b, so as to connect the ends of the second electrode finger portions 122a on that long side 14.

The first electrode 121 and the second electrode 122 are arranged so that the first electrode finger portions 121a and the second electrode finger portions 122a are alternately arranged along the direction in which the long sides 14 of the solar cell 11 extend. In this case, the lengths of the first electrode finger portions 121a and the second electrode finger portions 122a are approximately a half of the lengths of the first electrode busbar portion 121b and the second electrode busbar portion 122b. Therefore, a carrier collection loss due to the line resistance of the first electrode finger portions 121a and the second electrode finger portions 122a is reduced. Further, in one preferred embodiment, the conductive connecting member 50 is electrically connected to the linearly shaped first electrode busbar portion 121b of the first electrode 121 extending along the first end 11a of the solar cell 11, and the conductive connecting member 50 is electrically connected to the linearly shaped second electrode busbar portion 122b of the second electrode 122 extending along the second end 11b of the solar cell 11.

In one preferred embodiment, the large-sized solar cell 11X is designed so as to yield two identical solar cells 11 by dividing the same. Therefore, in one preferred embodiment, the first conductivity type area and the second conductivity type area are patterned on the large-sized semiconductor substrate 111X in such a manner that these areas are bilaterally symmetrical about the center of the substrate. The identical solar cells 11 obtained from the large-sized solar cell 11X as described above each have a divided end that helps making handling of each divided solar cell 11 easier, which, for example, improves workability at a time of forming the solar cell string 10. In particular, in the solar cell 11 shown in FIG. 6 obtained by dividing the large-sized solar cell 11X formed in a semi-square shape as shown in FIG. 5 into two pieces, the first electrode busbar portion 121b and the second electrode busbar portion 122b are easily distinguishable from each other, that is, the one extending along the long side 14 with the cut-out portions 13 is the first electrode busbar portion 121b and the one extending along the long side 14 without the cut-out portion 13 is the second electrode busbar portion 122b. This allows easier handling of the divided solar cells 11.

An example of a method for dividing the large-sized solar cell 11X is a laser machining. In this case, a laser beam is applied along a division line of the large-sized solar cell 11X to form a groove which is easily breakable, along which the large-sized solar cell 11X can be divided by bending into two pieces. This groove may be formed on the light receiving surface side or on the back surface side.

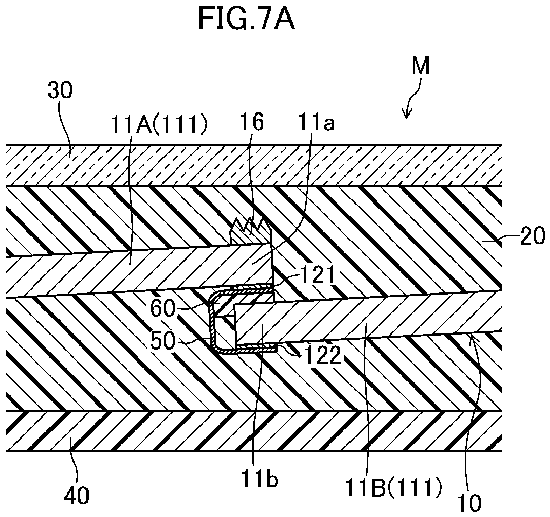

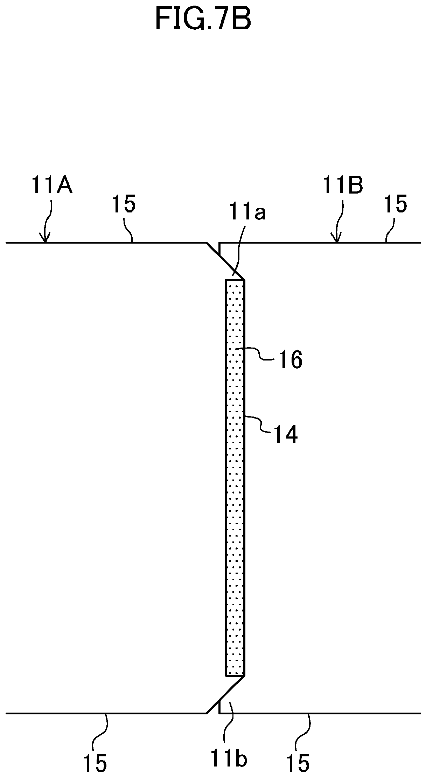

The one solar cell 11A may have a reflector 16 along its long side 14, on the light receiving surface of the first end 11a so as to correspond to the outer peripheral edge of the large-sized solar cell 11X, as shown in FIG. 7A and FIG. 7B.

At a time of manufacturing the large-sized solar cell 11X, there is a high possibility that the film thickness of the semiconductor thin film at the outer peripheral edges becomes uneven. Further, the surfaces of the outer peripheral edges of the large-sized solar cell 11X are likely to be subjected to abrasion or a scratch during handling at the time of manufacturing. Therefore, in the solar cell 11 obtained from the large-sized solar cell 11X, the power generation efficiency tends to be relatively lower at the portions corresponding to the outer peripheral edges of the large-sized solar cell 11X, as compared to the portion corresponding to the center of the large-sized solar cell 11X, due to a greater power generation loss caused by carrier recombination or the like.

However, with the reflector 16 in the portion on the light receiving surface side corresponding to the outer peripheral edge of the large-sized solar cell 11X, light applied to the area of the reflector 16 is reflected on the reflector 16 and is not directly incident on the solar cell 11. The light reflected on the reflector 16 is reflected again on another member and the like, and is incident on the solar cell 11 from an area where the reflector 16 is not arranged, thus contributing generation of power. The reflected light does not necessarily have to be incident on the solar cell 11 having the reflector 16 that has reflected the light, and may be incident on another solar cell 11 in the solar cell string 10. This reduces power generation loss caused by light incident on a portion with a low power generation efficiency, which corresponds to the outer peripheral edges of the large-sized solar cell 11X, and achieves a high-power output by causing the light having been reflected on the reflector 16 to be incident on an area with a high power generating efficiency (a normal area in the center of the plane of the cell).

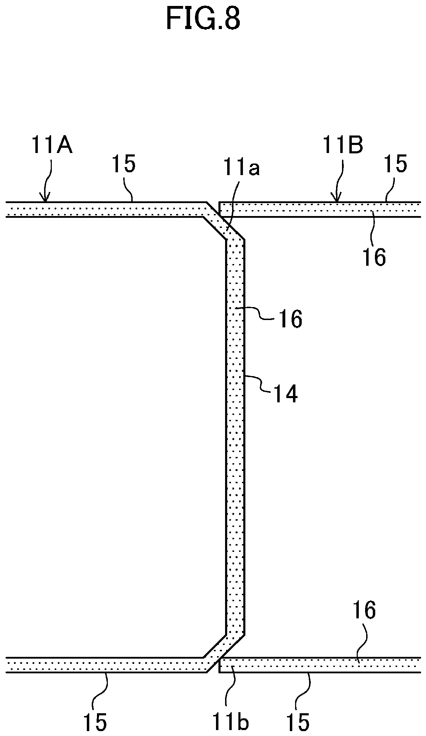

The reflector 16 may be provided at least in a portion on the light receiving surface of the first end 11a of the one solar cell 11A. For example, as shown in FIG. 8, the reflector 16 may be either arranged along both the long and short sides 14 and 15 of the solar cell 11, or arranged only along the short sides 15 of the solar cell 11.

The material for the reflector 16 is not particularly limited as long as the material can reflect light, but is preferably a metal such as copper, aluminum, silver, gold, tin, or an alloy of these, for the reason that these materials have high reflectance. As long as the reflector 16 has light reflectivity on its light receiving surface side, the reflector 16 may be a reflecting member having a reflective layer of a metal or the like on a surface of a resin material. The reflector 16 may be arranged either by printing a metal layer or the like, or attaching a reflective member.

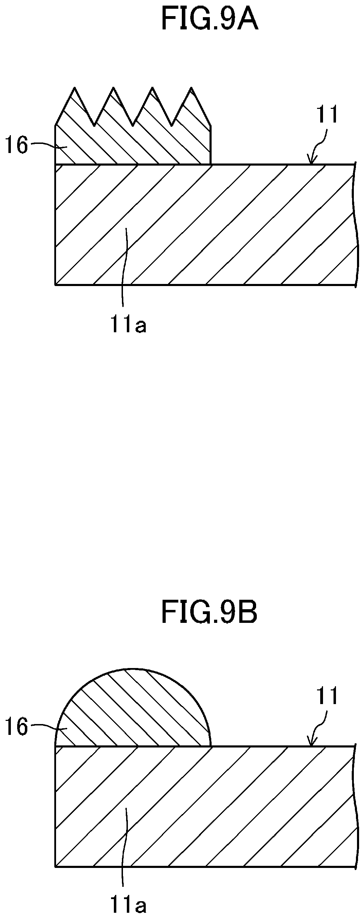

To reflect light in an oblique direction to increase the amount of reflected light incident on other portions, the reflector 16 may have unevenness on its surface on the light receiving surface side. For the same reason, the reflector 16 may have a surface inclined with respect to the light receiving surface of the solar cell 11. For example, as shown in FIG. 9A, ridges each having a triangular cross-section and extending in a length direction (the direction in which the short sides 15 extend) may be aligned in a width direction. The inclination angles of the slopes of the ridges of the reflector 16 which each have a triangular cross-section are set to a predetermined range so that light reflected on the reflector 16 is incident on the light receiving surface side protective member 30 at an increased incident angle. This increases the reflectance at the interface between the light receiving surface side protective member 30 and the air, and causes the light reflected on the reflector 16 to be reflected on the light receiving surface side protective member 30 and be incident on the solar cell 11. Thus, the amount of light incident is increased and the power generation efficiency is improved. Further, the reflector 16 may have a curved surface on its light receiving surface side and may have, for example, a ridge having a semicircular cross-section as illustrated in FIG. 9B.

The material of the encapsulant layer 20 has a high light transmittance and a high resistance to ultraviolet radiation in one preferred embodiment. It is also preferred that the material of the encapsulant layer 20 be highly adhesive to the solar cells 11 included in the solar cell string 10, the light receiving surface side protective member 30, and the back surface side protective member 40. The material for the encapsulant layer 20 may be, for example, a light-transmissive resin such as an ethylene/vinyl acetate copolymer (EVA), an ethylene/α-olefin copolymer, ethylene/vinyl acetate/triallyl isocyanurate (EVAT), polyvinyl butyrate (PVB), an acrylic resin, a urethane resin, or a silicone resin. The encapsulant layer 20 may be formed of a single material, or different materials may be used for the portion on the light receiving surface side and for the portion on the back surface side of the solar cell string 10. The material of the encapsulant layer 20 may contain an additive such as an organic peroxide, a silane coupling agent, an ultraviolet absorber, a wavelength conversion additive, a crosslinking aid, a heat stabilizer, and a light stabilizer.

The material of the light receiving surface side protective member 30 has a high light transmittance and a high resistance to ultraviolet radiation in one preferred embodiment. Examples of the material for the light receiving surface side protective member 30 include glass and a transparent resin such as an acrylic resin or a polycarbonate resin. Unevenness may be formed on the surface on the light receiving surface side of the light receiving surface side protective member 30. The surface on the light receiving surface side of the light receiving surface side protective member 30 may be covered with an antireflection coating layer. Such an antireflection coating layer, when arranged, reduces reflection of light and guides more light to the solar cell 11.

The material of the back surface side protective member 40 has high water blocking properties so as to restrict entry of water and the like in one preferred embodiment. Examples of the material for the back surface side protective member 40 include polyethylene terephthalate (PET), an olefin resin such as polyethylene (PE), a fluorine-containing resin, a silicone-containing resin and the like. The back surface side protective member 40 may have light reflectivity. The back surface side protective member 40 having the light reflectivity has a metallic color or a white color in one preferred embodiment, and may be formed of, for example, a white resin film or a lamination including a metal foil such as aluminum sandwiched between resin films. Further, the back surface side protective member 40 may have light absorbency. The back surface side protective member 40 having light absorbency is made of a material with a black exterior appearance, such as a black resin layer or the like, in one preferred embodiment. The back surface side protective member 40 of black color has an exterior appearance resembling the solar cell string 10 including the plurality of solar cells 11. Therefore, the solar cell module M will have high design characteristics with its entire surface uniformly black. Note that the back surface side protective member 40 may have light transparency.

The solar cell module M of the present embodiment is manufactured as follows. That is, the plurality of solar cells 11 are connected and linked one after another by using the conductive connecting member 50 to make the solar cell string 10. Then, a sheet material for forming the light receiving surface side protective member 30, a sheet material for forming the encapsulant layer 20 on the light receiving surface side, the solar cell string 10, a sheet material for forming the encapsulant layer 20 on the back surface side, and the back surface side protective member 40 are layered in this order. This stack is heated and pressurized at a predetermined temperature and a predetermined pressure, by using a laminator or the like which performs evacuation.

### [Examples]

### (Solar Cell Module)

The solar cell modules of the following Examples 1 to 3 and Comparative Example were manufactured.

### <Example 1>

First, a plurality of solar cells similar to that shown in FIG. 6 were prepared with an n-type single crystal silicon substrate as the semiconductor substrate, the p-type electrode as the first electrode, and the n-type electrode as the second electrode. Using these solar cells, a plurality of solar cell strings were manufactured (see FIG. 1A and FIG. 1B). In each of the solar cell strings, the first end of one of a given pair of solar cells adjacent to each other was arranged to overlap, by 1.5 mm, with the light receiving surface side of the second end of the other solar cell. The first electrode busbar portion on the back surface of the first end of the one solar cell and the second busbar portion on the back surface of the second end of the other solar cell were electrically connected to each other by soldering them to a conductive connecting member made of a strip of 50 µm-thick copper foil.

Then, a sheet material for forming the light receiving surface side protective member and a sheet material for forming the light receiving surface side of the encapsulant layer were layered in this order. The plurality of solar cell strings manufactured were arranged thereon so as to be spaced from one another in the width direction by 3 mm. At this time, ends of adjacent solar cell strings were electrically connected so that the plurality of solar cell strings were all continuous in a zigzag manner. In this manner, all of the solar cells were serially connected to one another. Next, a sheet material for forming the back surface side of the encapsulant layer and a back surface side protective member were layered in this order on the plurality of solar cell strings to obtain a layered body.

Then, the layered body was subjected to thermal pressure bonding under the atmospheric pressure for 5 minutes, using a laminator performing evacuation, and was then held at 150°C for 60 minutes to crosslink the encapsulant layer, thereby manufacturing a solar cell module of Example 1 similar to that shown in FIG. 1A and FIG. 1B.

A white plate glass was used as the sheet material for forming the light receiving surface side protective member. An EVA sheet was used as the sheet material for forming the light receiving surface side and the back surface side of the encapsulant layer. A layered sheet including a PET sheet and a black resin layer was used as the sheet material for forming the back surface side protective member.

### <Example 2>

A solar cell module of Example 2 similar to that shown in FIG. 4 was manufactured. The solar cell module of Example 2 was the same as that of Example 1 except that an insulative buffer member was interposed between the conductive connecting member and the other solar cell. For the insulative buffer member, an EVA sheet was used.

### <Example 3>

A solar cell module of Example 3 similar to those shown in FIG. 7A and FIG. 7B was manufactured. The solar cell module of Example 3 was the same as that of Example 2 except that a reflector extending along a long side was provided on the light receiving surface side of the first end of the one solar cell. For the reflector, a light diffusion tab wiring having a width of 2 mm was used. The light diffusion tab was made of a copper foil having an uneven structure on its surface, and the surface was coated with silver.

### <Comparative Example>

A solar cell module of Comparative Example was manufactured which was the same as that of Example 1 except that each solar cell adopted an n-type electrode as the first electrode and a p-type electrode as the second electrode.

### (Test Evaluation Method)

Conversion characteristics were measured for the respective solar cell modules of Examples 1 to 3 and Comparative Example, and a short-circuit current (Isc), an open voltage (Voc), a fill factor (FF), and a maximum output (Pmax) were determined. Then, relative values were calculated, with the characteristic values of Comparative Example set to 100.0.

### (Test Evaluation Result)

The test evaluation results are shown in Table 1.

**[Table 1]**

| | Example 1 | Example 2 | Example 3 | Comparative Example | |
|---|---|---|---|---|---|
| Conductivity Type of Semiconductor Substrate | n-type | n-type | n-type | n-type | |
| Second Electrode on Back Surface of Back Surface Side Cell | n-type electrode | n-type electrode | n-type electrode | p-type electrode | |
| Insulative Connecting Material | No | Yes | Yes | No | |
| Reflector | | No | No | Yes | No |
| Module Conversion Characteristics | Short-Circuit Current (Isc) | 100.4 | 100.2 | 98.8 | 100.0 |
| | Open Voltage (Voc) | 100.0 | 100.0 | 100.0 | 100.0 |
| | Fill Factor (FF) | 101.9 | 103.3 | 105.4 | 100.0 |
| | Maximum Output (Pmax) | 102.3 | 103.5 | 104.1 | 100.0 |

Table 1 shows that the fill factor (FF) of Example 1 is higher than that of Comparative Example, when Example 1 is compared to the Comparative Example. In Comparative Example, it is believed that the conductive connecting member connecting the n-type electrode on the back surface of the solar cell on the light receiving surface side and the p-type electrode on the back surface of the solar cell on the back surface side came into contact with the n-type single crystal silicon substrate of the solar cell on the back surface side, which generated a leak path, leading to a drop in the shunt resistance, thus deteriorating the performance. On the other hand, in Example 1, it is believed that a leak path was not formed and hence the shunt resistance was kept high even if the conductive connecting member connecting the p-type electrode on the back surface of the solar cell on the light receiving surface side and the n-type electrode on the back surface of the solar cell on the back surface side come into contact with the n-type single crystal silicon substrate of the solar cell on the back surface side, because the conductivity type of the conductive connecting member and the electrode were both n-type.

Comparison between Example 1 and Example 2 shows that Example 2 has a higher fill factor (FF) than Example 1. In Example 1, no insulative buffer member is provided between the conductive connecting member and the other solar cell on the back surface side. Therefore, it is believed that the solar cell strings might have included a solar cell having cracks caused by the conductive connecting member contacting the solar cell due to a pressure applied at the time of encapsulating the solar cell strings into the encapsulant layer, which consequently led to a drop in the output. Example 2, on the other hand, has the insulative buffer member between the conductive connecting member and the other solar cell on the back surface side. This insulative buffer member serves as a cushion when a pressure is applied at the time of encapsulating the solar cell strings into the encapsulant layer. Thus, it is believed that this structure kept the conductive connecting member from coming into contact with the solar cell, and therefore reduced cracks formed by such a contact, and avoided a drop in the output.

Comparison between Example 2 and Example 3 shows that Example 3 has a higher maximum output (Pmax) than Example 2. Example 3 has the reflector in a portion on the light receiving surface side of the first end of the solar cell, which portion corresponds to the outer peripheral edge of the large-sized solar cell and which has a relatively low power generation efficiency. It is therefore believed that the output was higher in Example 3 than in Example 2 because this reflector contributed to an increase in the amount of light incident on an area with a relatively high power generation efficiency.

### DESCRIPTION OF REFERENCE CHARACTERS

- M: Solar Cell Module
- 10: Solar Cell String
- 11, 11A, 11B: Solar Cell
- 11a: First End
- 11b: Second End
- 11X: Large-Sized Solar Cell
- 111: Semiconductor Substrate
- 111X: Large-Sized Semiconductor Substrate
- 121: First Electrode
- 121a: First Electrode Finger Portion
- 121b: First Electrode Busbar Portion
- 122: Second Electrode
- 122a: Second Electrode Finger Portion
- 122b: Second Electrode Busbar Portion
- 13: Cut-Out Portion
- 14: Long Side
- 15: Short Side
- 16: Reflector
- 20: Encapsulant Layer
- 30: Light Receiving Surface Side Protective Member
- 40: Back Surface Side Protective Member
- 50: Conductive Connecting Member
- 60: Insulative Buffer Member

## Claims

1. A solar cell module (M) comprising a plurality of solar cells (11) electrically connected and linked one after another, wherein
each of the plurality of solar cells (11) includes: an n-type or p-type semiconductor substrate (111) having one major surface on one side and the other major surface on the other side; an n-type semiconductor layer; and a p-type semiconductor layer, each of the plurality of solar cells (11) having, on the one major surface of the semiconductor substrate (111), a first electrode (121) that is one of an n-type electrode electrically connected to the n-type semiconductor layer or a p-type electrode electrically connected to the p-type semiconductor layer, and a second electrode (122) that is the other one of the n-type electrode or the p-type electrode, each of the plurality of solar cells (11) having a first end (11a) and a second end (11b) that extend parallel to each other,
in a given pair of solar cells (11) adjacent to each other out of the plurality of solar cells (11), the one major surface of the first end (11a) of one (11A) of the pair of solar cells (11) is overlapped with the other major surface of the second end (11b) of the other one (11B) of the pair of solar cells (11), the first electrode (121) of the one solar cell (11A) and the second electrode (122) of the other solar cell (11B) are electrically connected to each other via a conductive connecting member (50), and
a conductivity type of the semiconductor substrate (111) and a conductivity type of the semiconductor layer electrically connected to the second electrode (122) are n-type,
**characterized in that**
an insulative buffer member (60) is interposed between the conductive connecting member (50) and the other solar cell (11B) such that the insulative buffer member (60) is in contact with both the conductive connecting member (50) and the other solar cell (11B), and **in that** the insulative buffer member (60) is configured to act as a cushion between the conductive connecting member (50) and the other solar cell (11B).

2. The solar cell module (M) of claim 1, wherein
the insulative buffer member (60) is provided to cover the other major surface of the second end (11b) of the other solar cell (11B).

3. The solar cell module (M) of claim 1 or 2, wherein
the insulative buffer member (60) is transparent.

4. The solar cell module (M) of any one of claims 1 to 3, wherein
the conductive connecting member (50) is electrically connected to a linear portion or a portion made of a series of dots of the first electrode (121), the portion being arranged along the first end of the one solar cell (11A), and the conductive connecting member (50) is electrically connected to a linear portion or a portion made of a series of dots of the second electrode (122), the portion being arranged along the second end of the other solar cell (11B).

5. The solar cell module (M) of any one of claims 1 to 4, comprising a reflector (16) provided at least a portion of the other major surface of the first end of the one solar cell (11A).

6. The solar cell module (M) of claim 5, wherein the reflector (16) is provided on the other major surface of the one solar cell (11A) along a side of the first end (11a).

7. The solar cell module (M) of claim 5 or 6, wherein the reflector (16) has an uneven surface on the other major surface of the one solar cell (11A).

8. The solar cell module (M) of any one of claims 5 to 7, wherein
the reflector (16) has a surface inclined with respect to the other major surface of the one solar cell (11A).

## Patentansprüche

1. Solarzellenmodul (M) mit einer Mehrzahl von Solarzellen (11), die elektrisch verbunden und hintereinander verknüpft sind, wobei
die Mehrzahl von Solarzellen (11) jeweils aufweisen: ein n-Typ- oder p-Typ-Halbleitersubstrat (111) mit einer Hauptoberfläche auf einer Seite und der anderen Hauptoberfläche auf der anderen Seite; eine n-Typ-Halbleiterschicht und eine p-Typ-Halbleiterschicht, wobei jede der Mehrzahl von Solarzellen (11) auf der einen Hauptoberfläche des Halbleitersubstrats (111) eine erste Elektrode (121), die entweder eine n-Typ-Elektrode, die elektrisch mit der n-Typ-Halbleiterschicht verbunden ist, oder eine p-Typ-Elektrode, die elektrisch mit der p-Typ-Halbleiterschicht verbunden ist, und eine zweite Elektrode (122), die die andere von der n-Typ-Elektrode oder der p-Typ-Elektrode ist, aufweist, wobei jede der Mehrzahl von Solarzellen (11) ein erstes Ende (11a) und ein zweites Ende (11b), die sich parallel zueinander erstrecken, aufweist,
in einem gegebenen Paar von zueinander benachbarten Solarzellen (11) der Mehrzahl von Solarzellen (11) die eine Hauptoberfläche des ersten Endes (11a) Einer (11A) des Solarzellen-(11)-Paares mit der anderen Hauptoberfläche des zweiten Endes (11b) der Anderen (11B) des Solarzellen-(11)-Paares überlappt wird, die erste Elektrode (121) der einen Solarzelle (11A) und die zweite Elektrode (122) der anderen Solarzelle (11B) über ein leitendes Verbindungsglied (50) elektrisch miteinander verbunden sind, und
ein Leitfähigkeitstyp des Halbleitersubstrats (111) und ein Leitfähigkeitstyp der mit der zweiten Elektrode (122) elektrisch verbundenen Halbleiterschicht vom n-Typ sind,
**dadurch gekennzeichnet, dass**
ein isolierendes Pufferglied (60) zwischen dem leitenden Verbindungsglied (50) und der anderen Solarzelle (11B) angeordnet ist, so dass das isolierende Pufferglied (60) sowohl mit dem leitenden Verbindungsglied (50) als auch mit der anderen Solarzelle (11B) in Kontakt ist, und dass das isolierende Pufferglied (60) so ausgelegt ist, dass es als ein Kissen zwischen dem leitenden Verbindungsglied (50) und der anderen Solarzelle (11B) wirkt.

2. Solarzellenmodul (M) nach Anspruch 1, wobei das isolierende Pufferglied (60) vorgesehen ist, um die andere Hauptoberfläche des zweiten Endes (11b) der anderen Solarzelle (11B) abzudecken.

3. Solarzellenmodul (M) nach Anspruch 1 oder 2, wobei das isolierende Pufferglied (60) transparent ist.

4. Solarzellenmodul (M) nach einem der Ansprüche 1 bis 3, wobei das leitende Verbindungsglied (50) elektrisch mit einem linearen Abschnitt oder einem aus einer Reihe von Punkten bestehenden Abschnitt der ersten Elektrode (121) verbunden ist, wobei der Abschnitt entlang des ersten Endes der einen Solarzelle (11A) angeordnet ist, und das leitende Verbindungsglied (50) elektrisch mit einem linearen Abschnitt oder einem aus einer Reihe von Punkten bestehenden Abschnitt der zweiten Elektrode (122) verbunden ist, wobei der Abschnitt entlang des zweiten Endes der anderen Solarzelle (11B) angeordnet ist.

5. Solarzellenmodul (M) nach einem der Ansprüche 1 bis 4, mit einem Reflektor (16), der an wenigstens einem Abschnitt der anderen Hauptoberfläche des ersten Endes der einen Solarzelle (11A) vorgesehen ist.

6. Solarzellenmodul (M) nach Anspruch 5, wobei der Reflektor (16) auf der anderen Hauptoberfläche der einen Solarzelle (11A) entlang einer Seite des ersten Endes (11a) vorgesehen ist.

7. Solarzellenmodul (M) nach Anspruch 5 oder 6, wobei der Reflektor (16) eine unebene Oberfläche auf der anderen Hauptoberfläche der einen Solarzelle (11A) aufweist.

8. Solarzellenmodul (M) nach einem der Ansprüche 5 bis 7, wobei der Reflektor (16) eine Oberfläche aufweist, die in Bezug auf die andere Hauptoberfläche der einen Solarzelle (11A) geneigt ist.

## Revendications

1. Module de cellules solaires (M) comprenant une pluralité de cellules solaires (11) électriquement connectées et liées les unes à la suite des autres, dans lequel
chacune parmi la pluralité de cellules solaires (11) comprend : un substrat semi-conducteur de type n ou de type p (111) ayant une surface majeure sur un côté et une autre surface majeure sur l'autre côté ; une couche semi-conductrice de type n ; et une couche semi-conductrice de type p, chacune parmi la pluralité de cellules solaires (11) ayant, sur l'une surface majeure du substrat semi-conducteur (111), une première électrode (121) qui est l'une parmi une électrode de type n électriquement connectée à la couche semi-conductrice de type n et une électrode de type p électriquement connectée à la couche semi-conductrice de type p, et une deuxième électrode (122) qui est l'autre parmi l'électrode de type n et l'électrode de type p, chacune parmi la pluralité de cellules solaires (11) ayant une première extrémité (11a) et une deuxième extrémité (11b) qui s'étendent parallèlement l'une à l'autre,
dans une paire donnée de cellules solaires (11) adjacentes l'une à l'autre parmi la pluralité de cellules solaires (11), l'une surface majeure de la première extrémité (11a) de l'une (11A) parmi la paire de cellules solaires (11) est chevauchée par l'autre surface majeure de la deuxième extrémité (11b) de l'autre (11B) parmi la paire de cellules solaires (11), la première électrode (121) de l'une cellule solaire (11A) et la deuxième électrode (122) de l'autre cellule solaire (11B) sont électriquement connectées l'une à l'autre via un élément connecteur conducteur (50), et
le type de conductivité du substrat semi-conducteur (111) et le type de conductivité de la couche semi-conductrice électriquement connectée à la deuxième électrode (122) sont de type n,
**caractérisé en ce qu'**un élément tampon isolant (60) est interposé entre l'élément connecteur conducteur (50) et l'autre cellule solaire (11B) de façon que l'élément tampon isolant (60) soit en contact avec à la fois l'élément connecteur conducteur (50) et l'autre cellule solaire (11B), et **en ce que** l'élément tampon isolant (60) est configuré pour agir comme un amortissement entre l'élément connecteur conducteur (50) et l'autre cellule solaire (11B).

2. Module de cellules solaires (M) selon la revendication 1, dans lequel l'élément tampon isolant (60) est prévu de manière à couvrir l'autre surface majeure de la deuxième extrémité (11b) de l'autre cellule solaire (11B).

3. Module de cellules solaires (M) selon la revendication 1 ou 2, dans lequel l'élément tampon isolant (60) est transparent.

4. Module de cellules solaires (M) selon l'une quelconque des revendications 1 à 3, dans lequel l'élément connecteur conducteur (50) est électriquement connecté à une portion linéaire ou une portion faite d'une série de points de la première électrode (121), la portion étant disposée le long de la première extrémité de l'une cellule solaire (11A), et l'élément connecteur conducteur (50) est électriquement connecté à une portion linéaire ou une portion faite d'une série de points de la deuxième électrode (122), la portion étant disposée le long de la deuxième extrémité de l'autre cellule solaire (11B).

5. Module de cellules solaires (M) selon l'une quelconque des revendications 1 à 4, comprenant un réflecteur (16) prévu au niveau d'au moins une portion de l'autre surface majeure de la première extrémité de l'une cellule solaire (11A).

6. Module de cellules solaires (M) selon la revendication 5, dans lequel le réflecteur (16) est prévu sur l'autre surface majeure de l'une cellule solaire (11A) le long d'un côté de la première extrémité (11a).

7. Module de cellules solaires (M) selon la revendication 5 ou 6, dans lequel le réflecteur (16) a une surface irrégulière sur l'autre surface majeure de l'une cellule solaire (11A).

8. Module de cellules solaires (M) selon l'une quelconque des revendications 5 à 7, dans lequel le réflecteur (16) a une surface inclinée par rapport à l'autre surface majeure de l'une cellule solaire (11A).
